# EUROPEAN PATENT APPLICATION

(11) **EP 3 415 931 A1**
(43) Date of publication of application: **19.12.2018**
(21) Application number: 17176051.5
(22) Date of filing: 14.06.2017
(51) Int. Cl.: G01R 19/165, G08B 29/02, H02H 1/00, H04N 21/488, H02J 13/00

(54) **MAINS POWER SUPPLY MONITORING IN CONSUMER ELECTRONICS DEVICE AND METHOD**

(71) Applicant: Vestel Elektronik Sanayi ve Ticaret A.S., 45030 Manisa (TR)
(72) Inventor: ERDINÇ, Cihan, 45030 Manisa (TR); USLU, Mutlu, 45030 Manisa (TR)
(74) Representative: Flint, Adam

(57) **Abstract**

A mains power supply monitor (20) monitors the current and voltage of a mains power supply to a consumer electronics device (10). The mains power supply monitor (20) is arranged to determine that an irregularity in the mains power supply has occurred if one or more of (i) an incoming current is greater than a maximum allowable current threshold, or (ii) an incoming current is less than a minimum allowable current threshold, or (iii) an incoming voltage is greater than a maximum allowable voltage threshold, or (iv) an incoming voltage is less than a minimum allowable voltage threshold has occurred. The mains power supply monitor (20) at least one of records data concerning the irregularity at a local data storage device or transmits data concerning the irregularity to a remote station.

## Description

### Technical Field

The present disclosure relates to a device for monitoring a mains power supply supplied to a consumer electronic device and a method for monitoring a mains power supply supplied to a consumer electronic device.

### Background

Consumer electronic devices are sometimes returned to the manufacturer for repair or replacement because some fault has developed, or at least because the consumer believes that some fault has developed, such that the consumer device is not operating correctly. However, the manufacturer is often faced with a problem of not being able to identify correctly and/or efficiently the cause of the fault or the apparent fault.

### Summary

According to a first aspect disclosed herein, there is provided, in combination, a consumer electronics device and a mains power supply monitor for monitoring mains power supply to the consumer electronics device, the mains power supply monitor being constructed and arranged to:
monitor a current and voltage of a mains power supply being supplied to the consumer electronics device;
determine that an irregularity in the mains power supply has occurred if one or more of (i) an incoming current is greater than a maximum allowable current threshold, or (ii) an incoming current is less than a minimum allowable current threshold, or (iii) an incoming voltage is greater than a maximum allowable voltage threshold, or (iv) an incoming voltage is less than a minimum allowable voltage threshold has occurred; and
at least one of record data concerning the irregularity at a local data storage device or transmit data concerning the irregularity to a remote station.

It has been found that irregularities in a mains power supply supplied to a consumer electronics device can cause the consumer electronics device to malfunction. Irregularities can occur, for example, as a result of lightning strikes, illegal mains power supply usage and unplanned cuts to the mains power supply. Malfunctions can result in the consumer returning the consumer electronics device to the manufacturer. Examples described herein enable a manufacture to identify quickly that there has been some irregularity in the mains power supply to a consumer electronics device. This in turn enables the manufacturer to repair the consumer electronics device quickly if required and/or notify the consumer of potential problems with their mains power supply, which can even remove the need for a return of the consumer electronics device to the manufacturer as a repair may not in fact be required.

In an example, the mains power supply monitor is configured to continuously monitor the supplied current and voltage. This enables the instantaneous measurement of the supplied current and voltage.

In an example, the mains power supply monitor is configured to output a display concerning the irregularity to a display device for viewing by a user.

In an example, the mains power supply monitor is integral with the consumer electronics device. In another example, the mains power supply monitor is separate to the consumer electronics device.

In an example, the consumer electronics device is a media device. For example, the consumer electronics device may be a television set.

According to a second aspect disclosed herein, there is provided a method of monitoring irregularities in a mains power supply being supplied to a consumer electronics device, the method comprising:
monitoring a current and voltage of the mains power supply being supplied to the consumer electronics device;
determining that an irregularity in the mains power supply has occurred if one or more of (i) an incoming current is greater than a maximum allowable current threshold, or (ii) an incoming current is less than a minimum allowable current threshold, or (iii) an incoming voltage is greater than a maximum allowable voltage threshold, or (iv) an incoming voltage is less than a minimum allowable voltage threshold has occurred; and
at least one of recording data concerning the irregularity at a local data storage device or transmitting data concerning the irregularity to a remote station.

### Brief Description of the Drawings

To assist understanding of the present disclosure and to show how embodiments may be put into effect, reference is made by way of example to the accompanying drawings in which:
Figure 1 shows schematically an example of a consumer electronics device and a mains power supply for monitoring mains power supply to the consumer electronics device; and
Figure 2 shows schematically an example of a method of monitoring a mains power supply to a consumer electronics device.

### Detailed Description

There are several reasons why a consumer may return a consumer electronics device to the manufacturer after purchasing their device. One reason is that the device suffers from a malfunction.

There are many reasons why a consumer electronics device may malfunction. Example causes of malfunctions include one or more defective components, faulty design and environmental effects.

It has been appreciated that one particular problem that can cause consumer electronics devices to malfunction is irregularities in a mains power supply supplied to the device, at for example the consumer's premises. Irregularities can occur, for example, as a result of lightning strikes, illegal mains power supply usage and unplanned cuts to the mains power supply. Such irregularities can cause the powerboard of a consumer electronics device to malfunction and can even damage one or more components of the overboard and/or other parts of the consumer electronics device. Moreover, an irregularity in the mains power supply may lead the consumer to believe that some part of the consumer electronics device has malfunctioned or been damaged when in fact the problem may lie in the mains power supply.

Irregularities in the mains power supply can cause an unwanted peak or surge in the voltage supplied to the consumer electronics device. Similarly, irregularities in the mains power supply can cause an unwanted peak or surge in the current supplied to the consumer electronics device.

Irregularities in the mains power supply can also cause an unwanted drop or outage in the current supplied to the consumer electronics device. Similarly, irregularities in the mains power supply can cause an unwanted drop or outage in the current supplied to the consumer electronics device.

An example of an effect of such a peak or drop in the voltage or current supplied to the consumer electronics device is the malfunctioning of a powerboard of the consumer electronics device. For example, powerboard-based malfunctions can result from an irregularity in the mains power supply affecting or damaging the electronic components which are supplied with AC mains power. These components can include a fuse, a varistor, a diode bridge rectifier, a DC capacitor, a switch mode power supply IC, a switching transistor, etc. However, it has been appreciated that merely analysing the failed components may not indicate that there was some irregularity in the mains power supply.

Manufacturers suffer from several unwanted effects of consumers returning their devices including large costs, financial penalties and loss of prestige, labour and current and potential customers. It is therefore desirable to reduce the rate of return of consumer electronics devices and to identify quickly a problem that has arisen in a returned consumer electronics device.

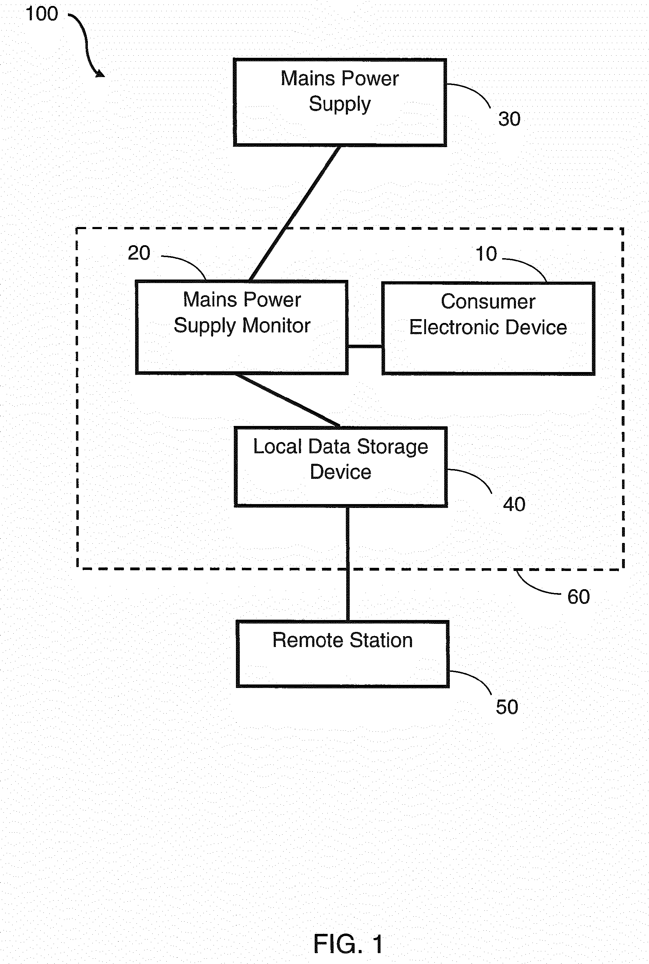

Referring to Figure 1, there is shown schematically an example of a consumer electronics device 10. The consumer electronics device 10 may be for example a media device such as a television set, a set top box, a DVD player, a personal computing device such as a laptop or desktop or tablet computer, a video game console, etc.

Figure 1 also shows a mains power supply monitor 20. The mains power supply monitor 20 has an input for receiving a mains power supply 30. The mains power supply monitor 20 has an output for outputting the mains power supply 10 to the consumer electronics device 10.

In an example, the mains power supply monitor 10 may be integral with the consumer electronics device 10. In an example, the mains power supply monitor 10 may be integrated with the consumer electronics device 10 during manufacture. In another example, the mains power supply monitor 10 may be separate from the consumer electronics device 10. In an example, the mains power supply monitor 10 may be retrofitted to the consumer electronics device 10 after manufacture.

The mains power supply monitor 20 is constructed and arranged to monitor the current and the voltage of a mains power supply 30 being supplied to the consumer electronics device 10. In an example, the mains power supply monitor 20 is configured to continuously monitor the supplied current and voltage. This is advantageous as it enables instantaneous measurement of the supplied current and voltage.

The mains power supply monitor 20 is constructed and arranged to determine that an irregularity in the mains power supply 30 has occurred. An irregularity in the mains power supply 10 corresponds to a peak or drop in the supplied current and/or voltage. For example, an irregularity occurs if the current and/or voltage supplied to the consumer electronics device 10 via the mains power supply monitor 20 is greater than a maximum threshold for the current and voltage respectively. In another example, an irregularity occurs if the current and/or voltage supplied to the consumer electronics device 10 via the mains power supply monitor 20 is less than a minimum threshold for the current and voltage respectively.

The mains power supply monitor 20 therefore determines that an irregularity in the mains power supply 30 has occurred if one or more of (i) an incoming current is greater than a maximum allowable current threshold, or (ii) an incoming current is less than a minimum allowable current threshold, or (iii) an incoming voltage is greater than a maximum allowable voltage threshold, or (iv) an incoming voltage is less than a minimum allowable voltage threshold has occurred.

In an example, the maximum and minimum current/voltage thresholds correspond to the allowable or specified operating range of current and voltage for the consumer electronics device 10.

In an example, if the mains power supply monitor 20 determines that an irregularity in the mains power supply 30 has occurred, the mains power supply monitor 20 will record data concerning the irregularity at a local data storage device 40. In an example, the local data storage device 40 is integral with the mains power supply monitor 20. In another example, the local data storage device 40 is integral with the consumer electronics device 10. In yet another example, the local data storage device 40 may be a standalone device.

Recording data concerning the irregularity at the local storage device 40 is advantageous as it may allow the consumer or user a view of such data, which in turn enables the consumer or user to determine the cause of a possible malfunction. For example, the mains power supply monitor 20 may be configured to output a display concerning the irregularity to a display device for viewing by a user. In another example, the manufacturer may use the display device to easily/quickly determine the cause of the malfunction.

Alternatively or additionally, in another example, if the mains power supply monitor 20 determines that an irregularity in the mains power supply 30 has occurred, the mains power supply monitor 20 will transmit data concerning the irregularity to a remote station 50.

In an example, the remote station 50 is located at or associated with the manufacturer. In another example, the remote station 50 is located at a data analysis centre. In an example, the data concerning the irregularity is transmitted from the mains power supply monitor 20 to the remote station 50 over the internet. For example, the mains power supply monitor 20 may be connected to the internet via a wired or wireless connection. One example of a consumer electronics device 10 that is connectable to the internet is a so-called "smart" television set.

Transmitting data concerning the irregularity to a remote station 50 is advantageous as the manufacturer may monitor the mains power supply 30 supplied to the mains power supply monitor 20. The manufacturer may send a message to the user of the consumer electronics device 10 regarding the irregularity. In an example, the user may be informed that there is not a fault with the consumer electronics device 10 and therefore the consumer electronics device 10 does not require returning to the manufacturer.

In another example, data concerning irregularities in the mains power supply 30 may be used to identify problems with the user's mains power supply 30. For example, the user may be warned about such a problem and provided with a recommendation to fix their mains power supply to prevent possible or further malfunctioning of the consumer electronics device 10 (and other devices at the user's premises).

Such warnings or recommendations may be sent to the user via for example email or a (SMS or short message service) text, and/or may be displayed automatically on the consumer electronics device 10 in the case that the consumer electronics device 10 has a display screen. Such warnings or recommendations can be regarded as being pre-emptive as they may help avoid an unnecessary return of the consumer electronics device 10 to the manufacturer.

The mains power supply monitor 20 may be configured to automatically inform the user of a problem with their mains power supply 30. In another example, the user may be informed of such a problem after data concerning the irregularity is analysed at the remote station 50.

The mains power supply monitor 20 may be or have one or more processors, or may be or have a microcontroller or the like. The mains power supply monitor 20 may have one or more memories for storing data, which may be persistent memories for storage of data. The mains power supply monitor 20 may have one or more memories for storing program instructions and data during execution of a computer program by the mains power supply monitor 20, which may be volatile memories.

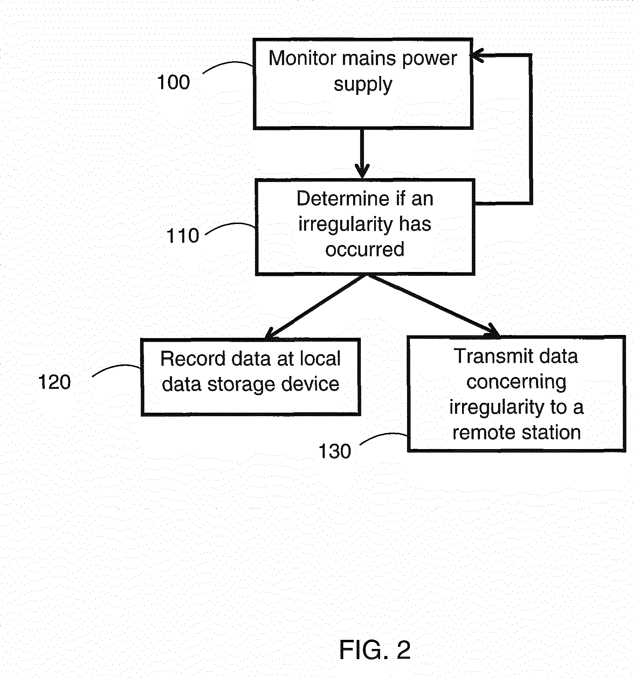

Referring to Figure 2, in an example method, at 100 the mains power supply monitor 20 monitors the mains power supply to the consumer electronics device 10. At 110, the mains power supply monitor 20 determines if an irregularity in the mains powers supply has occurred. This may be continual (i.e. carried out constantly, at for example predetermined intervals) or continuous, as indicated by the loop back from 110. If an irregularity has occurred then data concerning the irregularity may be stored at a local data storage device at 120 and/or data concerning the irregularity may be transmitted to a remote station 50.

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors and a digital signal processor or processors, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Reference is made herein to data storage for storing data. This may be provided by a single device or by plural devices. Suitable devices include for example a hard disk and non-volatile semiconductor memory.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. In combination, a consumer electronics device and a mains power supply monitor for monitoring mains power supply to the consumer electronics device, the mains power supply monitor being constructed and arranged to:
monitor a current and voltage of a mains power supply being supplied to the consumer electronics device;
determine that an irregularity in the mains power supply has occurred if one or more of (i) an incoming current is greater than a maximum allowable current threshold, or (ii) an incoming current is less than a minimum allowable current threshold, or (iii) an incoming voltage is greater than a maximum allowable voltage threshold, or (iv) an incoming voltage is less than a minimum allowable voltage threshold has occurred; and
at least one of record data concerning the irregularity at a local data storage device or transmit data concerning the irregularity to a remote station.

2. A combination according to claim 1, wherein the mains power supply monitor is configured to continuously monitor the supplied current and voltage.

3. A combination according to claim 1 or claim 2, wherein the mains power supply monitor is configured to output a display concerning the irregularity to a display device for viewing by a user.

4. A combination according to any of claims 1 to 3, wherein the mains power supply monitor is integral with the consumer electronics device.

5. A combination according to any of claims 1 to 4, wherein the consumer electronics device is a television set.

6. A method of monitoring irregularities in a mains power supply being supplied to a consumer electronics device, the method comprising:
monitoring a current and voltage of the mains power supply being supplied to the consumer electronics device;
determining that an irregularity in the mains power supply has occurred if one or more of (i) an incoming current is greater than a maximum allowable current threshold, or (ii) an incoming current is less than a minimum allowable current threshold, or (iii) an incoming voltage is greater than a maximum allowable voltage threshold, or (iv) an incoming voltage is less than a minimum allowable voltage threshold has occurred; and
at least one of recording data concerning the irregularity at a local data storage device or transmitting data concerning the irregularity to a remote station.

7. A method according to claim 6, wherein the monitoring the supplied current and voltage comprises continuously monitoring the supplied current and voltage.

8. A method according to claim 6 or claim 7, comprising outputting a display concerning the irregularity to a display device for viewing by a user.

9. A method according to any of claims 6 to 8, wherein the consumer electronics device is a television set.
